# EUROPEAN PATENT SPECIFICATION

(11) **EP 2 367 217 B1**
(45) Date of publication and mention of the grant of the patent: **22.07.2015**
(21) Application number: 11250334.7
(22) Date of filing: 17.03.2011
(51) Int. Cl.: H01L 51/52, H01L 27/32, G06F 3/041, G06F 3/042

(54) **Touch controlled display device having an organic light emitting diode display**
Berührungsgesteuerte Anzeigevorrichtung mit einer organischen lichtemittierenden Diodenanzeige
Dispositif d'affichage à commande tactile doté d'un affichage à diode électroluminescente organique

(30) Priority: 17.03.2010 KR 20100023899
(43) Date of publication of application: 21.09.2011
(73) Proprietor: Samsung Display Co., Ltd., Gyeonggi-Do (KR)
(72) Inventor: Chung, Jin-Koo, Yongin-City, Gyunggi-Do 446-711 (KR)
(74) Representative: Mounteney, Simon James

(56) References cited:
- US-A1- 2005 046 341
- US-A1- 2005 082 966
- US-A1- 2006 220 544
- US-A1- 2009 128 508
- US-A1- 2009 315 816

## Description

### BACKGROUND

### Field

The present invention relates generally to a touch controlled display device having an organic light emitting diode display.

### Description of the Related Technology

Touch controlled display devices are devices capable of controlling a display device by using touch. Touch controlled display devices using infrared rays have recently become popular.

Generally, touch controlled display devices using infrared rays include a display device displaying an image, an infrared-ray source irradiating infrared rays to a part where the image is displayed, and an infrared ray sensor sensing infrared rays reflected from the part where the image is displayed.

A screen display device for displaying an image onto a screen by using a projector, and a liquid crystal display device including a liquid crystal panel displaying an image by using a liquid crystal, and a backlight unit irradiating light to the liquid crystal panel are generally used.

Touch controlled display devices using infrared rays including a screen display device may have a problem in that a display quality of the image emitted from the projector and displayed on the screen may not be satisfactory due to the technical limits of the projector. The overall size of the touch controlled display devices may also be increased because a predetermined clearance space may be required between the projector and the screen.

Also, in some infrared-ray touch controlled display devices including a liquid crystal display device, the infrared rays irradiated from the infrared-ray source may need to be transmitted to the liquid crystal panel and the infrared rays reflected from the liquid crystal panel may need to be transmitted to the liquid crystal panel. In such devices, transmittance of the infrared rays to the liquid crystal panel may be deteriorated by a shutter function of the liquid crystal included in the liquid crystal panel. If transmittance of the infrared rays to the liquid crystal panel is deteriorated, the recognition rate of a touch to the touch controlled display device may be deteriorated.

US 2009/0128508 discloses a touch controlled display device according to the precharacterising portion of claim 1.

US 2009/0315816 also discloses a touch controlled display device.

The information disclosed in this Background section is merely for enhancement of understanding of the background of the described technology.

### SUMMARY OF CERTAIN INVENTIVE ASPECTS

The invention sets out to provide a touch controlled display device comprising an organic light emitting diode display having an improved infrared-ray transmittance.

The described technology has been made in an effort to provide a touch controlled display device having improved display quality, slim size, and improved touch recognition rate while using infrared rays as a touch recognition means, including the organic light emitting diode display having the improve infrared-rays transmittance.

The present invention provides a touch controlled display device according to claim 1.

Preferred features of the invention are set out in dependent claims 2 to 15.

### BRIEF DESCRIPTION OF THE DRAWINGS

FIG. 1 is a cross-sectional view of an embodiment of an organic light emitting diode display;
FIG. 2 is a layout view illustrating a structure of a pixel of the embodiment of an organic light emitting diode display of FIG. 1;
FIG. 3 is a cross-sectional view taken along line III-III of FIG. 2;
FIG. 4 is a scanning electron microscope (SEM) picture illustrating a transmission area included in the embodiment of an organic light emitting diode display of FIG. 1;
FIG. 5 is a layout view illustrating a structure of a pixel of another embodiment of an organic light emitting diode display;
FIG. 6 is an SEM picture illustrating a transmission area included in the embodiment of an organic light emitting diode display of FIG. 5;
FIG. 7 is a layout view illustrating a structure of a pixel of another embodiment of an organic light emitting diode display;
FIG. 8 is a layout view illustrating a structure of a pixel of another embodiment of an organic light emitting diode display;
FIG. 9 is a cross-sectional view of an embodiment of a touch controlled display device;
FIG. 10 is a cross-sectional view of main parts in the embodiment of a touch controlled display device of FIG. 9;
FIG. 11 is a cross-sectional view of another embodiment of a touch controlled display device; and
FIG. 12 is a cross-sectional view of another embodiment of a touch controlled display device.

### DETAILED DESCRIPTION

Embodiments of the invention will be described more fully hereinafter with reference to the accompanying drawings, in which certain embodiments are shown. As those skilled in the art would realize, the described embodiments may be modified in various ways, without departing from the scope of the present invention.

The drawings and description are to be regarded as illustrative in nature and not restrictive. Like reference numerals generally designate like elements throughout the specification.

The size and thickness of each component shown in the drawings are arbitrarily shown for understanding and ease of description.

In the drawings, the thickness of layers, films, panels, regions, and the like are exaggerated for clarity. It will be understood that when an element such as a layer, film, region, or substrate is referred to as being "on" or "below" another element, it can be "directly on" or "directly below" the other element, or intervening elements may also be present.

Throughout the disclosure, unless explicitly described to the contrary, the word "comprise" and variations such as "comprises" or "comprising", will be understood to imply the inclusion of stated elements but not the exclusion of any other elements. Further, throughout the specification, "on" or "below" implies being positioned above or below a target element and does not imply being necessarily positioned on the top or on the basis of a gravity direction.

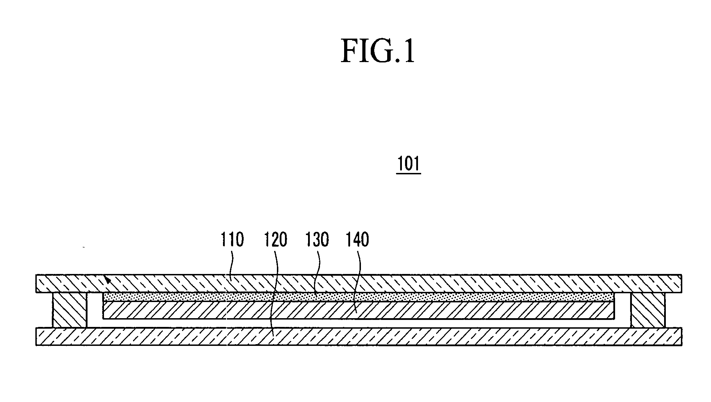

Hereinafter, referring to FIGS. 1 through 4, an embodiment of an organic light emitting diode display will be described.

FIG. 1 is a cross-sectional view of an embodiment of an organic light emitting diode display.

The organic light emitting diode display 101 includes a first substrate 110, a second substrate 120, a wiring part 130, and an organic light emitting element 140.

The first substrate 110 and the second substrate 120 may be an optically transmissive and electrically insulating substrate, containing glass, a polymer, or the like. The first substrate 110 and the second substrate 120 face each other and are attached to one another by a sealant. The wiring part 130 and the organic light emitting element 140 are positioned between the first substrate 110 and the second substrate 120. The first substrate 110 and the second substrate 120 may protect the wiring part 130 and the organic light emitting element 140 from external interference.

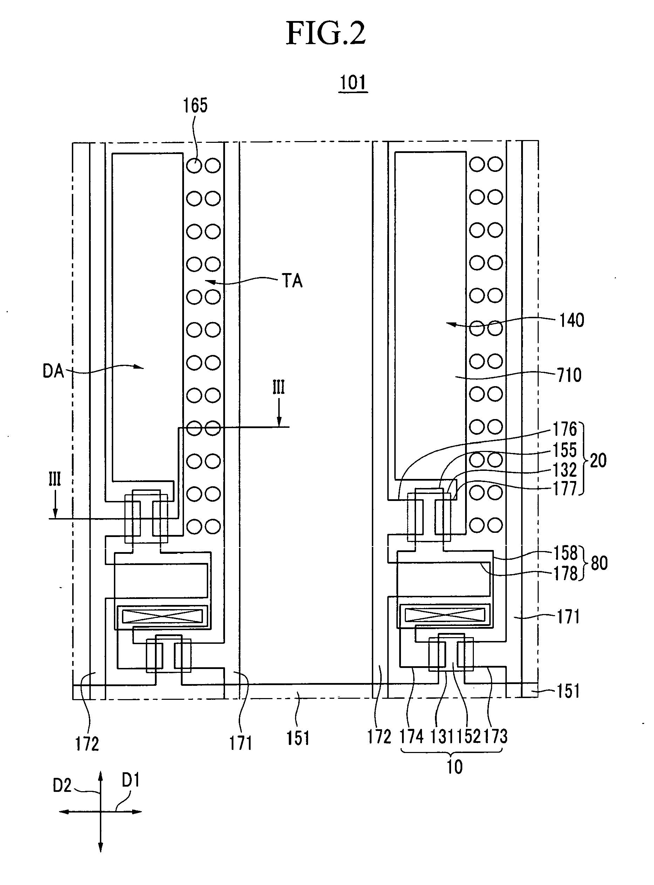

The wiring part 130 includes switching and driving thin film transistors 10 and 20 (shown in FIG. 2) and may transmit a driving signal to the organic light emitting element 140 to drive the organic light emitting element 140. The organic light emitting element 140 may emit light depending on the signal transmitted from the wiring part 130.

The organic light emitting element 140 is positioned on the wiring part 130.

The organic light emitting element 140 is positioned at a display region on the first substrate 110 and may be formed by a vacuum deposition method using a mask, by a printing method, or the like. The organic light emitting element 140 may receive the signal from the wiring part 130 and may display an image by the received signal.

The organic light emitting diode display 101 includes a transmission area TA (shown in FIG. 2) where light irradiated from the outside is transmitted, and a display area DA (shown in FIG. 2) displaying the image.

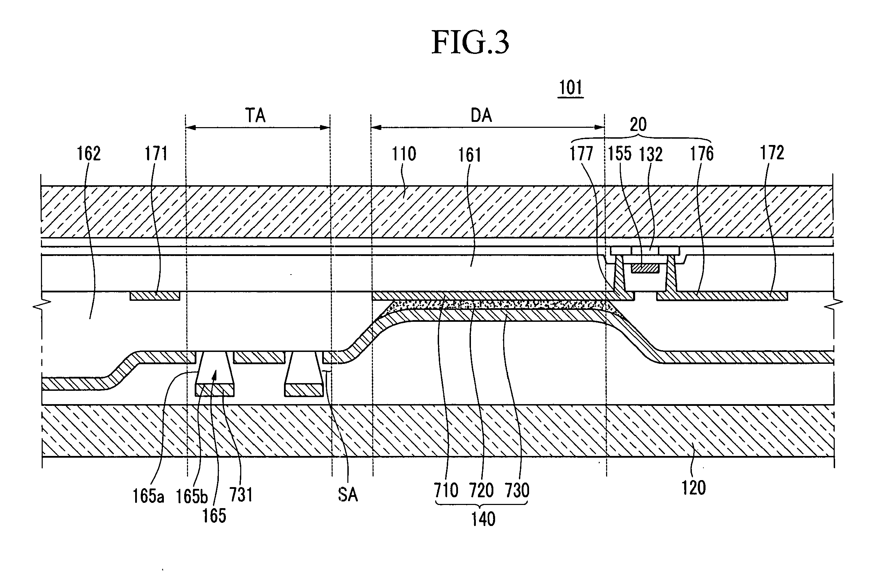

FIG. 2 is a layout view illustrating a structure of a pixel of the embodiment of an organic light emitting diode display of FIG. 1. FIG. 3 is a cross-sectional view taken along line III-III of FIG. 2.

One embodiment of the detailed structures of the wiring part 130 and the organic light emitting element 140 is shown in FIGS. 2 and 3. In other embodiments, the wiring part 130 and the organic light emitting element 140 may be formed in various different structures which can be easily modified by those skilled in the art. In some embodiments, the organic light emitting diode display may be an active matrix (AM) type organic light emitting diode display having a 2Tr-lCap structure, which is provided with two thin film transistors (TFTs) and one storage capacitor in one pixel as shown. In other embodiments, the number of thin film transistors, the number of storage capacitors, and the number of wires may vary. A pixel represents the minimum unit displaying an image and the organic light emitting diode display generally displays the image through a plurality of pixels.

As shown in FIGS. 2 and 3, the organic light emitting diode display 101 includes a switching thin film transistor 10, a driving thin film transistor 20, a storage capacitor 80, and an organic light emitting element 140 for each pixel.

In this embodiment, the wiring part 130 includes the switching thin film transistor 10, the driving thin film transistor 20, and the storage capacitor 80. The wiring part 130 also includes a gate line 151 disposed in a first direction D1 of the first substrate 110, and a data line 171 and a common power supply line 172 insulatively crossing the gate line 151 in a second direction D2 crossing the first direction D1. In this embodiment, a boundary of one pixel may be defined by the gate line 151, the data line 171, and the common power line 172.

The switching thin film transistor 10 includes a switching semiconductor layer 131, a switching gate electrode 152, a switching source electrode 173, and a switching drain electrode 174. The driving thin film transistor 20 includes a driving semiconductor layer 132, a driving gate electrode 155, a driving source electrode 176, and a driving drain electrode 177.

The switching thin film transistor 10 serves as a switch that selects a pixel to emit light. The switching gate electrode 152 is connected to the gate line 151. The switching source electrode 173 is connected to the data line 171. The switching drain electrode 174 is separate from the switching source electrode 173 and is connected to any one storage plate 158.

The driving thin film transistor 20 applies driving voltage to allow an organic light emitting layer 720 of the organic light emitting element 140 in the selected pixel to emit light to a first pixel electrode 710. The driving gate electrode 155 is connected to the storage plate 158 connected with the switching drain electrode 174. Each of the driving source electrode 176 and the other storage plate 178 is connected to the common power supply line 172. A first electrode 710 of the organic light emitting element 140 extends from the driving drain electrode 177 and the driving drain electrode 177 and the first electrode 710 are interconnected.

The storage capacitor 80 includes the pair of storage plates 158 and 178 with an interlayer insulating layer 161 interposed therebetween. In this embodiment, the interlayer insulating layer 161 is made of a dielectric material, and a capacitance of the storage capacitor 80 is determined by an electric charge stored in the storage capacitor 80 and voltage between storage plates 158 and 178.

The switching thin film transistor 10 is driven by gate voltage applied to the gate line 151, and transmits data voltage, applied to the data line 171, to the driving thin film transistor 20. A voltage corresponding to a difference between common voltage applied to the driving thin film transistor 20 from the common power supply line 172, and the data voltage transmitted from the switching thin film transistor 10, is stored in the storage capacitor 80. Current corresponding to the voltage stored in the storage capacitor 80 flows to the organic light emitting element 140 through the driving thin film transistor 20 to allow the organic light emitting element 140 to emit light.

The organic light emitting element 140 includes a first electrode 710, an organic light emitting layer 720 formed on the first electrode 710, and a second electrode 730 formed on the organic light emitting layer 720. The organic light emitting layer 720 emitting light is positioned between the first electrode 710 and the second electrode 730 facing each other.

In one embodiment, the first electrode 710 may be an anode, serving as a hole injection electrode, and the second electrode 730 may be a cathode, serving as an electron injection electrode. In other embodiments, the first electrode 710 may be the cathode and the second electrode 730 may be the anode according to a driving method of the organic light emitting diode display 101. Holes and electrons may be injected into the organic light emitting layer 720 from the first electrode 710 and the second electrode 730, respectively. When an exciton generated by a combination of the holes and the electrons injected into the organic light emitting layer 720 falls from an excited state to a ground state, the organic light emitting layer 720 emits light. In some embodiments, the first electrode 710 may include a single-layered or multilayered light transmitting conductive material including at least one of indium tin oxide (ITO), indium zinc oxide (IZO), and the like. In some embodiments, the second electrode 730 may include a single-layered or multilayered light reflecting conductive material including at least one of aluminum (Al), silver (Ag) and the like. In such embodiments, the first electrode 710 may be light-transmissive and the second electrode 730 may be light-reflective. In some embodiments, the organic light emitting layer 720 may further include at least one of an electron injection layer, an electron transport layer, a hole injection layer, and a hole transport layer.

In this embodiment of the organic light emitting diode display 101, the organic light emitting element 140 emits light in the direction of the first substrate 110. The organic light emitting diode display 101 is therefore a backlight type displaying an image by emitting light in an upper direction of the organic light emitting diode display 101.

The organic light emitting diode display 101 further includes the transmission area TA and the display area DA.

The display area DA includes the first electrode 710, the organic light emitting layer 720, and the second electrode 730. The display area DA displays an image by using light emitted from the organic light emitting layer 720. The transmission area TA is positioned adjacent the display area DA.

A pixel defined layer 162 is positioned on the interlayer insulating layer 161 to expose the first electrode 710. The organic light emitting layer 720 and the second electrode 730 are positioned on the exposed first electrode 710. The pixel defined layer 162 may thus define the display area DA. In some embodiments, the pixel defined layer 162 may be formed by a light transmitting organic layer containing polyimide, polyacryl, or the like. In other embodiments, the pixel defined layer 162 may be formed by a light transmitting inorganic layer containing silicon nitride (SiNx), silicon oxide (Si02) or the like.

The transmission area TA transmits light irradiated from the outside and includes a protruding portion 165 and a portion 731 of the second electrode 730.

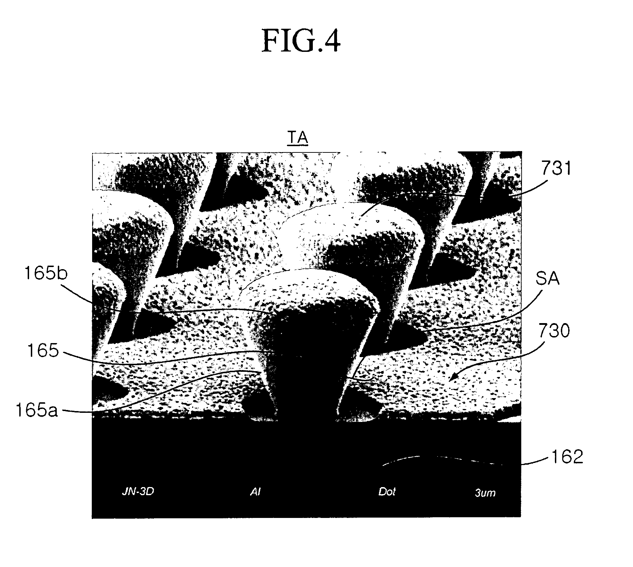

FIG. 4 is a scanning electron microscope (SEM) picture illustrating a transmission area included in this embodiment of an organic light emitting diode display of FIG. 1.

As shown in FIGS. 2 to 4, a plurality of protruding portions 165 are positioned between the first electrode 710 and the data line 171, and are positioned at a portion of the pixel defined by the gate line 151, the data line 171, and the common power supply line 172. Each protruding portion 165 protrudes from the pixel defined layer 162 and includes the same material used to form the pixel defined layer 162. The protruding portions 165 are spaced from each other and each has an island configuration. The side 165a of each protruding portion 165 is inversely tapered. The second electrode 730 is formed throughout the organic light emitting element 140 by using a deposition process. The sides 165a of the protruding portions 165 are inversely tapered, such that a portion 731 of the second electrode 730 is deposited on the top 165b of each protruding portion 165, but the second electrode 730 is not deposited on the sides 165a of the protruding portions 165.

The portions 731 of the second electrode 730 that are seated on the top 165b of the protruding portions 165 are spaced from the entire second electrode 730 by spacing areas SA. Light irradiated from the outside can be transmitted through the spacing area SA. The transmission area TA is formed by the spacing areas SA formed by the protruding portions 165 and the light irradiated from the outside is transmitted through the transmission area TA.

The portion 731 of the second electrode 730 that is deposited on the top 165b of each protruding portion 165 is dependent on at least the width and the height of the protruding portion 165 itself, the size of the gap between neighboring protruding portions 165, and the inclination level of the side 165a of the protruding portion 165. The dimension of the spacing area SA formed between a portion 731 of the second electrode 730 and the entire second electrode 730 may be selected to suit preferred operational characteristics of the device. For example, the dimension of the spacing areas SA may be increased to increase the transmission of the light irradiated from the outside. As the height of the protruding portions 165 increases, the distance between the portion 731 of the second electrode 730 deposited on the top 165b of the protruding portion 165 and the second electrode 730 increases, such that the dimension of the spacing area SA increases. The dimension of the spacing area SA is in proportion to the height of the protruding portion 165 and as the height of the protruding portion 165 increases, deposition interference of the second electrode 730 by the protruding portion 165 occurs, such that the dimension of the spacing area SA increases to thereby improve external light transmittance through the transmission area TA. In some embodiments, the protruding portion 165 may be formed using a MEMS process such as photolithography, and the like. In one embodiment, the side 165b is inversely tapered using an etch ratio.

In the embodiment of FIG. 1, the protruding portions 165 of the organic light emitting diode display 101 are positioned between the first electrode 710 and the data line 171. In other embodiments, the protruding portions of the organic light emitting diode display may be positioned between the first electrode 710 and the common power supply line 172.

In this embodiment one layer protrudes from the pixel defined layer 162 to form the protruding portion 165 of the organic light emitting diode display 101. In other embodiments, a plurality of layers may protrude from the pixel defined layer 162 to form a laminated protruding portion.

One embodiment of the organic light emitting diode display 101 includes the transmission area TA where a portion 731 of the second electrode 730 is spaced from the entire second electrode 730 by the spacing area SA by the protruding portion 165, such that the light irradiated from the outside is transmitted through the spacing area SA. Since the light irradiated from the outside penetrates the organic light emitting diode display 101 through the transmission area TA, the organic light emitting diode display 101 is implemented as a fully transparent organic light emitting diode display 101.

The light irradiated from the outside penetrates the organic light emitting diode display 101 through the transmission area TA, such that when infrared rays are transmitted through the transmission area TA, infrared-ray transmittance of the organic light emitting diode display 101 is improved.

Other embodiments of the organic light emitting diode display are described below. Only characteristic parts of the organic light emitting diode display according to the other embodiments different than the organic light emitting diode display according to the embodiment of FIG. 1 will be described.

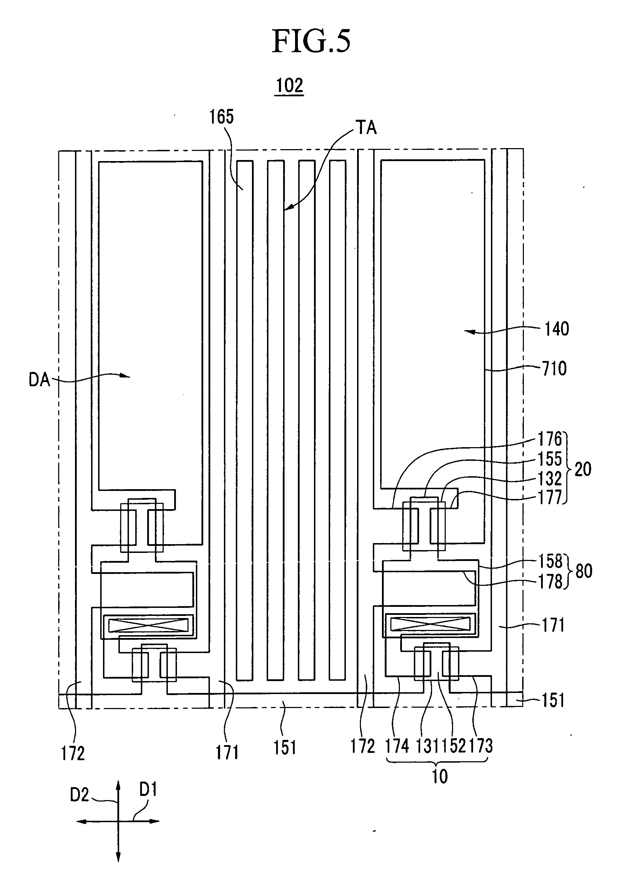

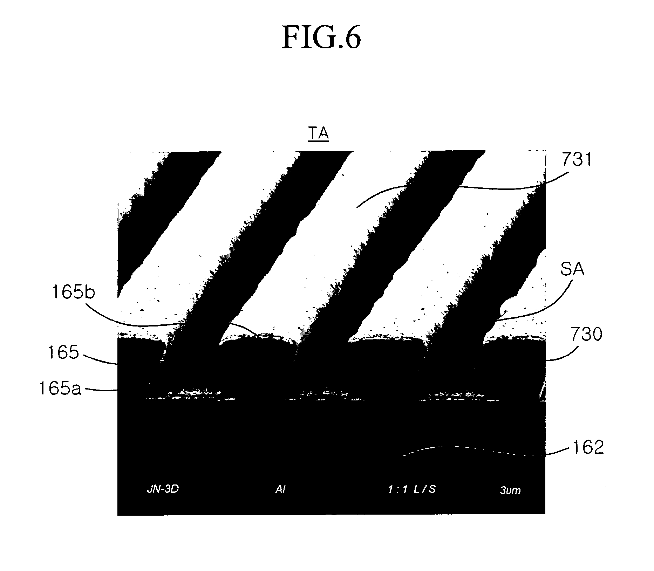

FIG. 5 is a layout view illustrating a structure of a pixel of another embodiment of an organic light emitting diode display. FIG. 6 is an SEM picture illustrating a transmission area included in the embodiment of an organic light emitting diode display of FIG. 5.

As shown in FIGS. 5 and 6, the transmission area TA transmits light irradiated from the outside and includes a protruding portion 165 and a portion 731 of the second electrode 730.

In this embodiment, the protruding portion 165 is positioned between a data line 171 of any one pixel among adjacent pixels and a common power supply line 172 of the other pixel and in addition, it is positioned between the adjacent pixels. There are a plurality of protruding portions 165 and the plurality extends in a second direction D2 parallel to an extension direction of the data line 171 and the common power supply line 172. The side 165a of the protruding portion 165 is inversely tapered. The second electrode 730 is formed throughout the organic light emitting element 140 by using a deposition process. The side 165a of the protruding portion 165 is inversely tapered, such that a portion 731 of the second electrode 730 is deposited on the top 165b of the protruding portion 165, but the second electrode 730 is not deposited on the side 165a of the protruding portion 165. A portion 731 of the second electrode 730 is seated on the top 165b of the protruding portion 165.

A portion 731 of each second electrode 730 is seated on the top 165b of the protruding portion 165 having the inversely tapered side 165a so as to be spaced from the entire electrode 730 by a spacing area SA. Portions 731 of the second electrodes 730 are spaced from the entire second electrode 730 by the spacing areas SA, such that the light irradiated from the outside can be transmitted through the spacing areas SA. The transmission area TA is formed by the spacing areas SA formed by the protruding portions 165 and the light irradiated from the outside is transmitted through the transmission area TA.

The protruding portion 165 of the organic light emitting diode display 102 in the embodiment of FIGS. 5 and 6 extends in the second direction D2 parallel to the extension direction of the data line 171 and the common power supply line 172. In other embodiments, a protruding portion of an organic light emitting diode display may extend in a first direction D1 parallel to an extension direction of a gate line 151.

In this embodiment, the organic light emitting diode display 102 includes the transmission area TA where portions 731 of the second electrode 730 are spaced from the entire second electrode 730 by the spacing areas SA by the protruding portion 165, such that the light irradiated from the outside is transmitted through the spacing area SA. Since the light irradiated from the outside penetrates the organic light emitting diode display 102 through the transmission area TA, the organic light emitting diode display 102 is implemented as a fully transparent organic light emitting diode display 102.

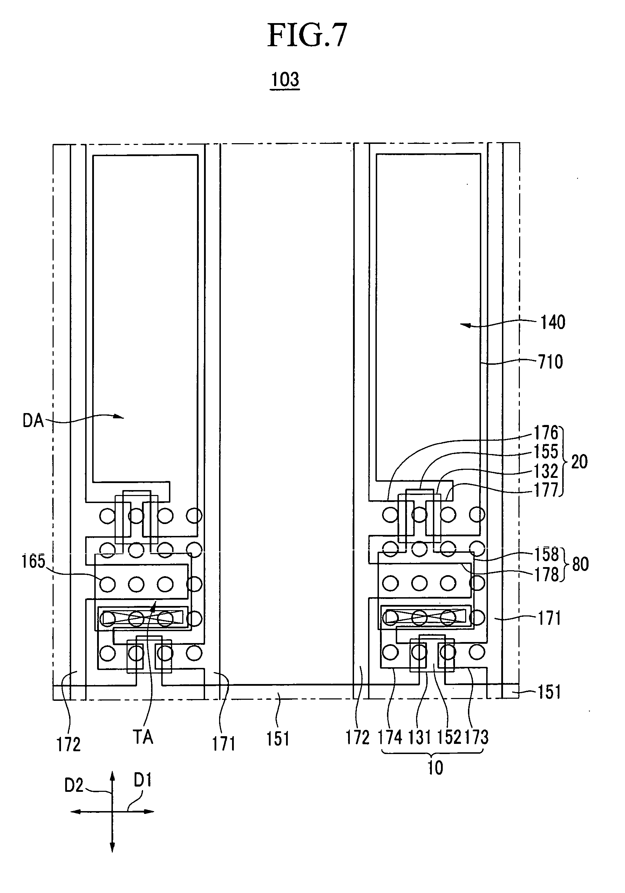

FIG. 7 is a layout view illustrating a structure of a pixel of another embodiment of an organic light emitting diode display.

In the embodiment shown in FIG. 7, the transmission area TA transmits light irradiated from the outside and includes a protruding portion 165 and a portion 731 of the second electrode 730.

The protruding portion 165 is positioned to correspond to a switching thin film transistor 10 and a driving thin film transistor 20 in a pixel defined by a gate line 151, a common power supply line 172, and a data line 171. A portion 731 of the second electrode 730 is spaced from the entire second electrode 730 by a spacing area SA on the top 165b of the protruding portion 165. Light irradiated from the outside is transmitted through the spacing area SA. The transmission area TA is formed by the spacing area SA formed by the protruding portion 165 and the light irradiated from the outside is transmitted through the transmission area TA.

Although the switching thin film transistor 10 and the driving thin film transistor 20 are positioned to correspond to the transmission area TA, the light transmitted through the spacing area SA from the outside may penetrate the organic light emitting diode display 103 through a space between wires constituting the switching thin film transistor 10 and a space between wires constituting the driving thin film transistor 20.

In the embodiment shown in FIG. 7, the organic light emitting diode display 103 includes the transmission area TA where a portion 731 of the second electrode 730 is spaced from the entire second electrode 730 by the spacing area SA by the protruding portion 165, such that the light irradiated from the outside is transmitted through the spacing area SA. Since the light irradiated from the outside penetrates the organic light emitting diode display 103 through the transmission area TA, the organic light emitting diode display 103 is implemented as a fully transparent organic light emitting diode display 103.

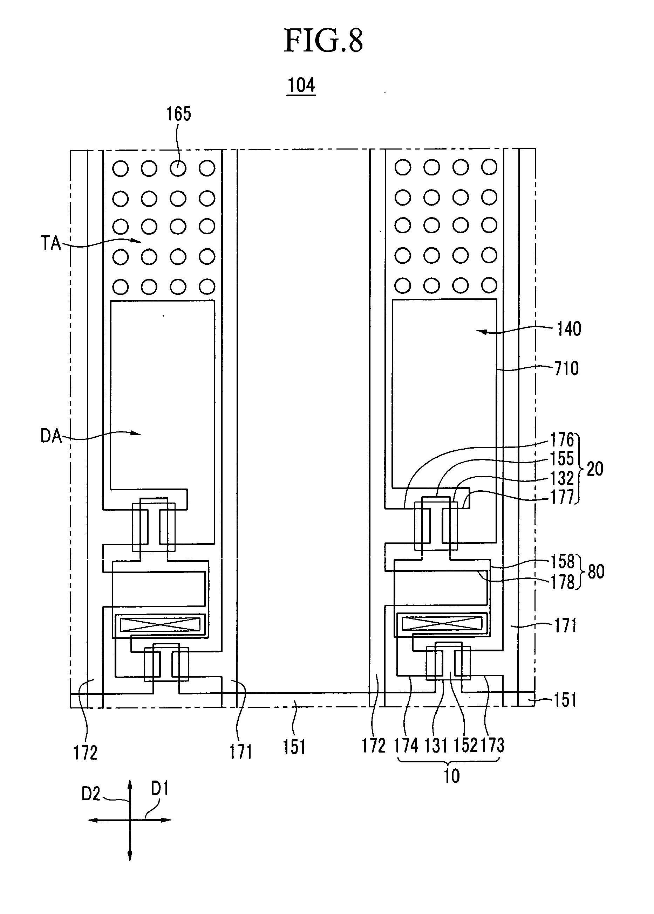

FIG. 8 is a layout view illustrating a structure of a pixel of another embodiment of an organic light emitting diode display. In the embodiment of FIG. 8, the transmission area TA transmits light irradiated from the outside and includes a protruding portion 165 and a portion 731 of the second electrode 730.

The protruding portion 165 is surrounded by a first electrode 710, a common power supply line 172, and a data line 171 in a pixel defined by a gate line 151, the common power supply line 172, and the data line 171. That is, the protruding portion 165 is adjacent to the first electrode 710, the common power supply line 172, and the data line 171.

The protruding portion 165 is positioned adjacent to the first electrode 710, the common power supply line 172, and the data line 171. A portion 731 of the second electrode 730 is spaced from the entire second electrode 730 by a spacing area SA on the top 165b of the protruding portion 165. Light irradiated from the outside is transmitted through the spacing area SA. The transmission area TA is formed by the spacing area SA formed by the protruding portion 165 and the light irradiated from the outside is transmitted through the transmission area TA.

In the embodiment shown in FIG. 8, the organic light emitting diode display 104 includes the transmission area TA where a portion 731 of the second electrode 730 is spaced from the entire second electrode 730 by the spacing area SA by the protruding portion 165, such that the light irradiated from the outside is transmitted through the spacing area SA. Since the light irradiated from the outside penetrates the organic light emitting diode display 104 through the transmission area TA, the organic light emitting diode display 104 is implemented as a fully transparent organic light emitting diode display 104.

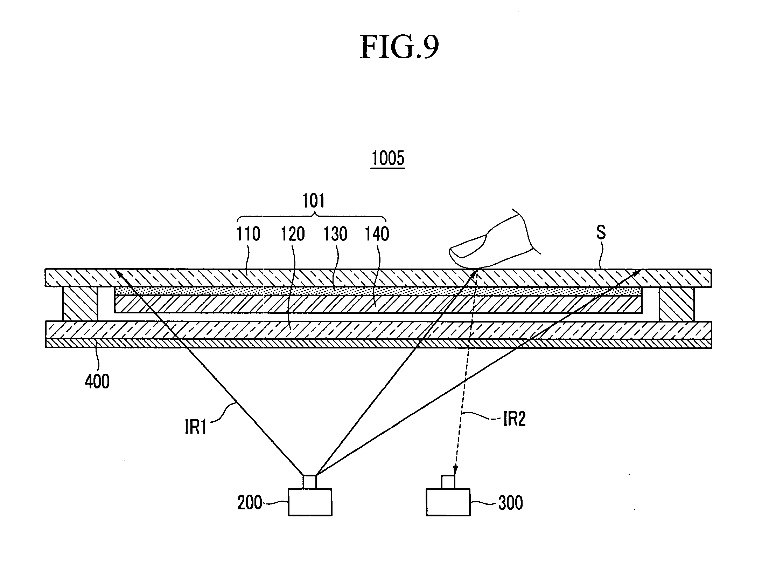

Referring to FIGS. 9 to 10, an embodiment of a touch controlled display device 1005 will be described. The embodiment of a touch controlled display device described includes the embodiment of the organic light emitting diode display 101 shown in FIG. 1 In other embodiments, the touch controlled display device may include other embodiments of the organic light emitting diode displays.

FIG. 9 is a cross-sectional view of an embodiment of a touch controlled display device.

In the embodiment shown in FIG. 9, the touch controlled display device 1005 recognizes a touch by using infrared rays and includes the embodiment of an organic light emitting diode display 101 shown in FIG. 1, an infrared-ray source 200, an infrared-ray sensor 300, and an infrared-ray transmission layer 400.

The organic light emitting diode display 101 includes a first substrate 110, a second substrate 120, a wiring part 130, and an organic light emitting element 140.

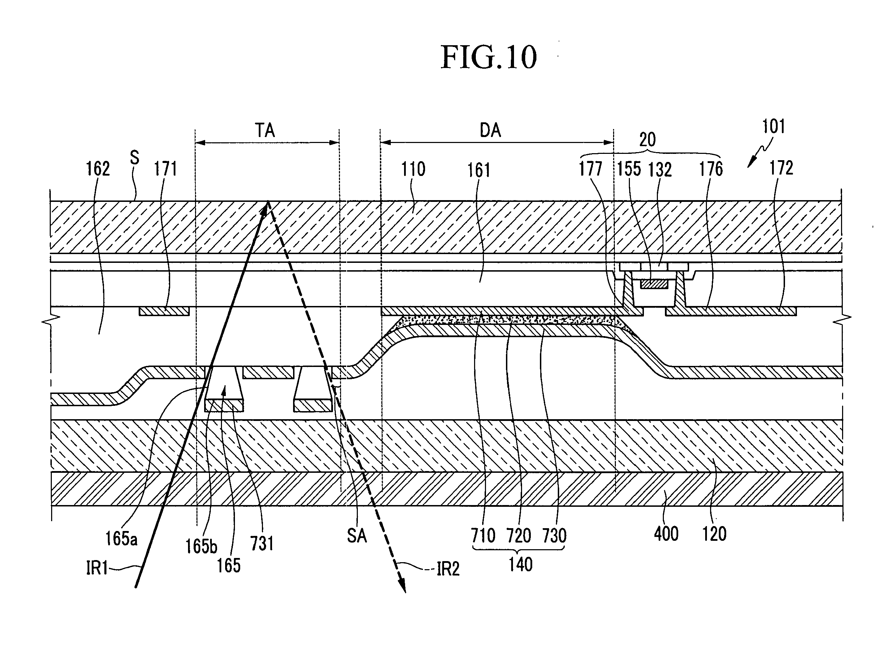

FIG. 10 is a cross-sectional view of main parts in the embodiment of a touch controlled display device of FIG. 9.

In the embodiment shown in FIG. 10, an embodiment of the organic light emitting diode display 101 includes a display area DA displaying an image and a transmission area TA transmitting light irradiated from the outside.

The transmission area TA of the organic light emitting diode display 101 transmits the light irradiated from the outside, and also transmits infrared rays. A first infrared ray IR1 irradiated from the infrared-ray source 200 is irradiated to the surface S of the first substrate 110 of the organic light emitting diode display 101 through a spacing area SA of the transmission area TA.

Referring to FIGS. 9 and 10, the infrared-ray source 200 is positioned below the organic light emitting diode display 101 and irradiates the first infrared ray IR1 in the direction of the organic light emitting diode display 101. The first infrared ray IRI irradiated in the direction of the organic light emitting diode display 101 from the infrared-ray source 200 is irradiated to the surface S of the first substrate 110 included in the organic light emitting diode display 101 through the spacing area SA of the transmission area TA of the organic light emitting diode display 101. The first infrared ray IR1 irradiated to the organic light emitting diode display 101 from the infrared-ray source 200 corresponds to the surface S of the organic light emitting diode display 101.

The amount of light of the first infrared ray IR1 is changed by a touch when the touch is performed on the surface S of the first substrate 110. The first infrared ray IR1 irradiated to the surface of the first substrate 110 from the infrared-ray source 200 is changed to a second infrared ray IR2 again reflected in the direction of the organic light emitting diode display 101. The second infrared ray IR2 is reflected from the surface S of the first substrate 110 and is irradiated to a lower direction of the organic light emitting diode display 101 through the spacing area SA of the transmission area TA of the organic light emitting diode display 101.

The infrared-ray sensor 300 is positioned below the organic light emitting diode display 101 and senses the second infrared ray IR2. The infrared-ray sensor 300 may determine a touch point with respect to the organic light emitting diode display 101 by sensing the second infrared ray IR2. A touch signal for the touch point determined by the infrared-ray sensor 300 may be transmitted to a controller driving the organic light emitting diode display 101 to thereby display an image depending on the touch signal on the organic light emitting diode display 101. The infrared-ray sensor 300 senses the surface S of the first substrate 110 by sensing the infrared rays irradiated to the infrared-ray sensor 300 even though the touch is not performed on the surface S of the first substrate 110 and determines the touch point with respect to the organic light emitting diode display 101 by sensing the second infrared ray IR2 having an amount of light changed by the touch among the infrared rays irradiated to the infrared-ray sensor 300. In some embodiments, the infrared-ray sensor 300 may be a camera sensing the infrared rays. In other embodiments, the infrared-ray sensor 300 may include a sensor sensing the infrared rays.

An infrared-ray transmission layer 400 is positioned between the organic light emitting diode display 101 and the infrared-ray sensor 300. The infrared-ray transmission layer 400 transmits the first infrared ray IR1 and the second infrared ray IR2. The infrared-ray transmission layer 400 blocks a wavelength of a visible light region among light emitted from the organic light emitting element 140 of the organic light emitting diode display 101. The light emitted from the organic light emitting element 140 is blocked by the infrared-ray transmission layer 400 to thereby minimize interference in the first infrared ray IR1 or the second infrared ray IR2 by the light emitted from the organic light emitting element 140.

The infrared-ray transmission layer 400 blocks the wavelength of the visible light region among the light emitted from the organic light emitting element 140, such that an inner part of the organic light emitting diode display 101 is prevented from being seen from the outside due to reflection of the light emitted from the organic light emitting element 140 by a constituent member positioned in the organic light emitting diode display 101. An overall display quality of the touch controlled display device 1005 is thus prevented from being deteriorated.

The infrared-ray transmission layer 400 blocks the light of the visible light region of external light irradiated to the infrared-ray transmission layer 400 through the spacing area SA of the transmission area TA and the light emitted from the organic light emitting element 140 to prevent an inner part of the touch controlled display device 1005 from being seen from the outside through the organic light emitting diode display 101.

The organic light emitting diode display 101 displaying the image includes the organic light emitting element 140 which is the self light emitting element, such that the touch controlled display device 1005 has an improved display quality than touch controlled display devices including a screen display displaying the image on a screen by using an liquid crystal display panel or a projector requiring an additional light emitting unit such as a backlight unit.

Since the organic light emitting display 101 included in the touch controlled display device 1005 can have a thinner thickness than the screen display included in touch controlled display devices including the projector and the screen, the entire touch controlled display device 1005 can be implemented to be slimmer.

In the touch controlled display device 1005, since the first infrared ray IR1 irradiated in the direction of the surface S of the organic light emitting diode display 101 from the infrared-ray source 200 and the second infrared ray IR2 reflected from the surface S of the organic light emitting diode display 101 by a touch can easily penetrate the organic light emitting diode display 101 through the spacing area SA of the transmission area TA, the overall infrared-ray transmittance to the organic light emitting diode display 101 is improved. The overall infrared-rays transmittance to the organic light emitting diode display 101 is improved by the spacing area SA formed in the transmission area TA to thereby improve the recognition rate of the touch to the touch controlled display device 1005.

Although the touch controlled display device 1005 substantially includes the transmission area TA transmitting light of all wavelengths, light of a visible light region wavelength is blocked by the infrared-ray transmission layer 400. Therefore, an inner part of the touch controlled display device 1005 is suppressed from being seen to the outside and as a result, the display quality of the touch controlled display device 1005 is improved.

Embodiments of the touch controlled display device 1005 have improved display quality, are slim, and have improved touch recognition rate by improving the infrared-rays transmittance while using the infrared rays as a touch recognition means.

Other embodiments of touch controlled display devices will be described below. Only characteristic parts of the touch controlled display devices different than the previously described embodiments will be described

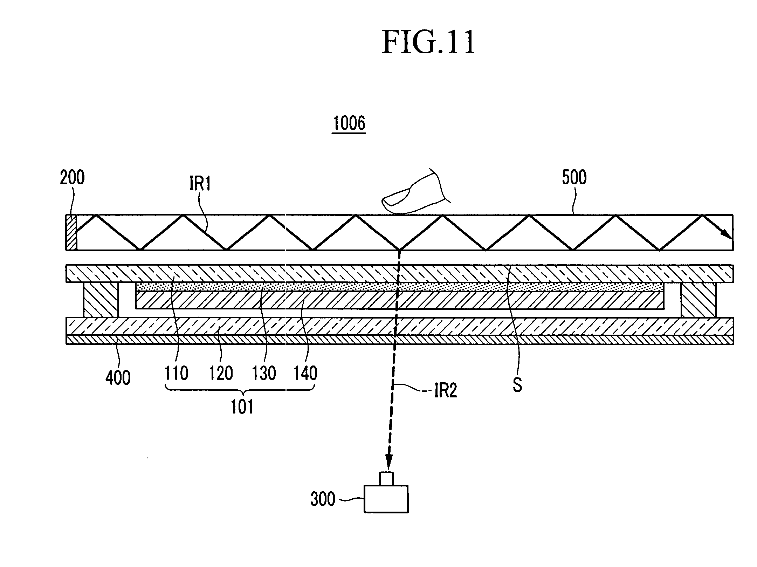

FIG. 11 is a cross-sectional view of another embodiment of a touch controlled display device.

In the embodiment shown in FIG. 11, the touch controlled display device 1006 includes an organic light emitting diode display 101, an infrared-ray source 200, an infrared-ray sensor 300, an infrared-ray transmission layer 400, and a total reflection plate 500.

The infrared-ray source 200 is positioned on the organic light emitting diode display 101. The infrared-ray source 200 is positioned on the end of the total reflection plate 500 and irradiates a first infrared ray IR1 to the inside of the total reflection plate 500. The first infrared ray IR1 irradiated to the inside of the total reflection plate 500 is total-reflected in a direction parallel to a plate surface of the total reflection plate 500 in the total reflection plate 500 to correspond to the surface S of a first substrate 100 included in the organic light emitting diode display 101. The first infrared ray IR1 irradiated to the inside of the total reflection plate 500 corresponds to the surface S of the organic light emitting diode display 101.

The total reflection plate 500 is positioned on the organic light emitting diode display 101 while being adjacent to the infrared-ray source 200 and total-reflects the first infrared ray IR1 irradiated from the infrared-ray source 200 therein. When a touch is made on the surface of the total reflection plate 500, total reflection of the first infrared ray IR1 total-reflected in the total reflection plate 500 is broken by the touch, and the first infrared ray IR1 is changed to a second infrared ray IR2 irradiated in the direction of the organic light emitting diode display 101. The second infrared ray IR2 is changed from the first infrared ray IR1 total-reflected, is irradiated to a lower side of the organic light emitting diode display 101 through a spacing area SA of a transmission area TA of the organic light emitting diode display 101, and is sensed by the infrared-ray sensor 300.

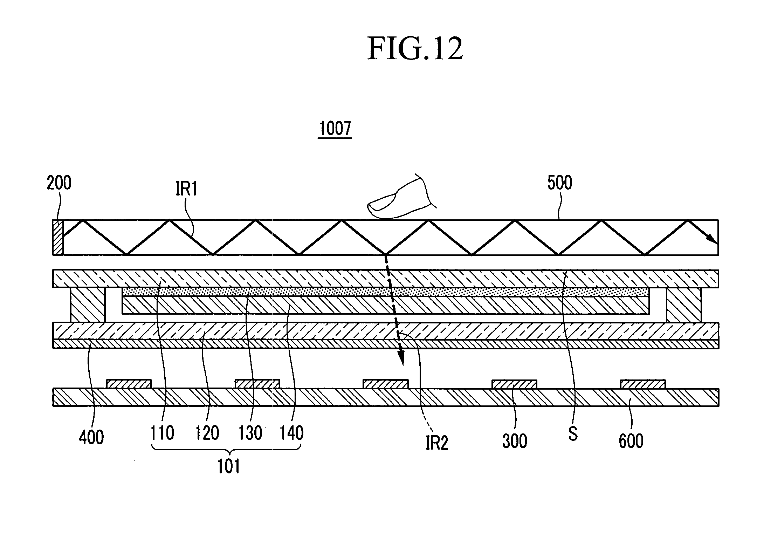

FIG. 12 is a cross-sectional view of another embodiment of a touch controlled display device.

In the embodiment shown in FIG. 12, the touch controlled display device 1007 includes an organic light emitting diode display 101, an infrared-ray source 200, an infrared-ray sensor 300, an infrared-ray transmission layer 400, a total reflection plate 500, and a sensing plate 600.

The infrared-ray source 200 is positioned on the organic light emitting diode display 101. The infrared-ray source 200 is positioned on the end of the total reflection plate 500 and irradiates a first infrared ray IR1 to the inside of the total reflection plate 500. The first infrared ray IR1 irradiated is total-reflected in a direction parallel to a plate surface of the total reflection plate 500 in the total reflection plate 500 to correspond to the surface S of a first substrate 110 included in the organic light emitting diode display 101. The first infrared ray IR1 irradiated to the inside of the total reflection plate 500 from the infrared-ray source 200 and total-reflected in the total reflection plate 500 corresponds to the surface S of the organic light emitting diode display 101.

The total reflection plate 500 is positioned on the organic light emitting diode display 101 while being adjacent to the infrared-ray source 200 and total-reflects the first infrared ray IR1 irradiated from the infrared-ray source 200 therein. When a touch is made on the surface of the total reflection plate 500, total reflection of the first infrared ray IR1 total-reflected in the total reflection plate 500 is broken by the touch and the first infrared ray IR1 is changed to a second infrared ray IR2 irradiated in the direction of the organic light emitting diode display 101. The second infrared ray IR2 is changed from the first infrared ray IR1 total-reflected, is irradiated to a lower side of the organic light emitting diode display 101 through a transmission area TA of the organic light emitting diode display 101, and is sensed by the infrared-rays sensor 300.

There may be a plurality of infrared-ray sensors 300 these may be mounted on a sensing plate 600.

The sensing plate 600 is positioned below the organic light emitting diode display 101 and is mounted with the plurality of infrared-rays sensors 300. The plurality of infrared-rays sensors 300 mounted on the sensing plate 600 may be all formed on the sensing plate 600 by using a MEMS process such as photolithography, and the like.

## Claims

1. A touch controlled display device (1005), comprising:
an organic light emitting diode display (101);
an infrared-ray source (200) configured to irradiate a first infrared ray to a surface of the organic light emitting diode display; and
an infrared-ray sensor (300) positioned below the organic light emitting diode display and configured to sense a second infrared ray that is directed in the direction of the organic light emitting diode display from the first infrared ray by a touch and transmitted throughout a transmission area of the organic light emitting diode display,
**characterized in that** the organic light emitting diode display (101) comprises:
a display area comprising an organic light emitting layer (720) emitting light, and a first electrode (710) and a second electrode (730) facing each other, the organic light emitting layer interposed between the first and second electrodes; and
the transmission area being adjacent to the display area and comprising a portion (731) of the second electrode (730) that is spaced from the remainder of the second electrode by a spacing area and a protruding portion (165) on which the portion of the second electrode is seated;
wherein the display is configured to transmit light irradiated from the outside through the spacing area.

2. A touch controlled display device according to claim 1, wherein the organic light emitting diode display (101) further comprises: a thin film transistor (20) comprising a source electrode (176) and drain electrode (174) configured to transmit a driving signal to the first electrode (710).

3. A touch controlled display device according to claim 1 or 2, wherein the organic light emitting diode display further comprises a pixel defined layer (162) defining the display area by exposing the first electrode (710), wherein the protruding portion (165) protrudes from the pixel defined layer.

4. A touch controlled display device according to any preceding claim, wherein a side of the protruding portion (165) is inversely tapered.

5. A touch controlled display device according to any preceding claim, wherein the protruding portion (165) has an island configuration.

6. A touch controlled display device according to any preceding claim, wherein the protruding portion (165) extends in one direction.

7. A touch controlled display device according to any preceding claim, wherein the transmission area comprises a plurality of protruding portions (165).

8. A touch controlled display device according to claim 7, wherein the protruding portions (165) are arranged in an array pattern.

9. A touch controlled display device according to claim 7, wherein the protruding portions (165) are arranged in a striped pattern.

10. A touch controlled display device according to any preceding claim, wherein the first electrode (710) is light transmissive, and the second electrode (730) is light reflective.

11. A touch controlled display device according to any one of the preceding claims, further comprising:
an infrared-ray transmission layer (400) positioned between the organic light emitting diode display (101) and the infrared-ray sensor (300), configured to transmit the second infrared ray.

12. A touch controlled display device according to claim 11, wherein:
the infrared-ray transmission layer (400) blocks a wavelength of a visible light region.

13. A touch controlled display device according to any one of the preceding claims, wherein:
the infrared-ray source (200) is positioned below the organic light emitting diode display (101), configured to irradiate the first infrared ray onto the surface of the organic light emitting diode display through the transmission area of the organic light emitting diode display, and
the touch is made on the organic light emitting diode display.

14. A touch controlled display device according to one of the preceding claims, wherein:
the infrared-ray source (200) is positioned on the organic light emitting diode display, the touch controlled display device further comprises a total reflection plate (500) positioned on the organic light emitting diode display, adjacent to the infrared-ray source (200) and configured to total-reflect the first infrared ray irradiated from the infrared-ray source therein, and
the touch is made onto the total reflection plate (500).

15. A touch controlled display device according to claim 13 or 14, further comprising:
a sensing plate (600) positioned below the display panel, wherein the infrared-ray sensor (300) is mounted on the sensing plate.

## Patentansprüche

1. Berührungsgesteuerte Anzeigevorrichtung (1005), umfassend:
eine organische lichtemittierende Diodenanzeige (101);
eine Infrarotstrahlquelle (200), die dazu ausgestaltet ist, einen ersten Infrarotstrahl zu einer Oberfläche der organischen lichtemittierenden Diodenanzeige auszustrahlen; und
einen Infrarotstrahlsensor (300), der unter der organischen lichtemittierenden Diodenanzeige angeordnet ist und dazu ausgestaltet ist, einen zweiten Infrarotstrahl zu erfassen, der von dem ersten Infrarotstrahl durch eine Berührung in Richtung der organischen lichtemittierenden Diodenanzeige gerichtet und durch einen gesamten Übertragungsbereich der organischen lichtemittierenden Diodenanzeige hindurch übertragen wird,
**dadurch gekennzeichnet, dass** die organische lichtemittierende Diodenanzeige (101) umfasst:
einen Anzeigebereich, der eine organische lichtemittierende Schicht (720), die Licht emittiert, und eine erste Elektrode (710) und eine zweite Elektrode (730), die einander zugewandt sind, umfasst, wobei die organische lichtemittierende Schicht zwischen der ersten und zweiten Elektrode angeordnet ist; und
wobei der Übertragungsbereich dem Anzeigebereich benachbart ist und einen Abschnitt (731) der zweiten Elektrode (730), der vom Rest der zweiten Elektrode durch einen Beabstandungsbereich beabstandet ist, und einen vorspringenden Abschnitt (165), auf den der Abschnitt der zweiten Elektrode aufgesetzt ist, umfasst;
wobei die Anzeige dazu ausgestaltet ist, von außen ausgestrahltes Licht durch den Beabstandungsbereich hindurch zu übertragen.

2. Berührungsgesteuerte Anzeigevorrichtung nach Anspruch 1, wobei die organische lichtemittierende Diodenanzeige (101) weiterhin umfasst: einen Dünnschichttransistor (20), der eine Source-Elektrode (176) und eine Drain-Elektrode (174) umfasst, die dazu ausgestaltet sind, ein Ansteuersignal an die erste Elektrode (710) zu übertragen.

3. Berührungsgesteuerte Anzeigevorrichtung nach Anspruch 1 oder 2, wobei die organische lichtemittierende Diodenanzeige weiterhin eine pixeldefinierte Schicht (162) umfasst, die durch Freilegen der ersten Elektrode (710) den Anzeigebereich definiert, wobei der vorspringende Abschnitt (165) von der pixeldefinierten Schicht vorspringt.

4. Berührungsgesteuerte Anzeigevorrichtung nach einem vorangehenden Anspruch, wobei sich eine Seite des vorspringenden Abschnitts (165) umgekehrt verjüngt.

5. Berührungsgesteuerte Anzeigevorrichtung nach einem vorangehenden Anspruch, wobei der vorspringende Abschnitt (165) eine Inselkonfiguration aufweist.

6. Berührungsgesteuerte Anzeigevorrichtung nach einem vorangehenden Anspruch, wobei sich der vorspringende Abschnitt (165) in einer Richtung erstreckt.

7. Berührungsgesteuerte Anzeigevorrichtung nach einem vorangehenden Anspruch, wobei der Übertragungsbereich eine Mehrzahl vorspringender Abschnitte (165) umfasst.

8. Berührungsgesteuerte Anzeigevorrichtung nach Anspruch 7, wobei die vorspringenden Abschnitte (165) in einem Anordnungsmuster angeordnet sind.

9. Berührungsgesteuerte Anzeigevorrichtung nach Anspruch 7, wobei die vorspringenden Abschnitte (165) in einem Streifenmuster angeordnet sind.

10. Berührungsgesteuerte Anzeigevorrichtung nach einem vorangehenden Anspruch, wobei die erste Elektrode (710) lichtdurchlässig ist und die zweite Elektrode (730) lichtreflektierend ist.

11. Berührungsgesteuerte Anzeigevorrichtung nach einem der vorangehenden Ansprüche, weiterhin umfassend:
eine Infrarotstrahlübertragungsschicht (400), die zwischen der organischen lichtemittierenden Diodenanzeige (101) und dem Infrarotstrahlsensor (300) angeordnet ist, die dazu ausgestaltet ist, den zweiten Infrarotstrahl zu übertragen.

12. Berührungsgesteuerte Anzeigevorrichtung nach Anspruch 11, wobei:
die Infrarotstrahlübertragungsschicht (400) eine Wellenlänge eines sichtbaren Lichtbereichs sperrt.

13. Berührungsgesteuerte Anzeigevorrichtung nach einem der vorangehenden Ansprüche, wobei:
die Infrarotstrahlquelle (200) unter der organischen lichtemittierenden Diodenanzeige (101) angeordnet ist, dazu ausgestaltet ist, den ersten Infrarotstrahl durch den Übertragungsbereich der organischen lichtemittierenden Diodenanzeige hindurch auf die Oberfläche der organischen lichtemittierenden Diodenanzeige auszustrahlen, und
die Berührung auf der organischen lichtemittierenden Diodenanzeige erfolgt.

14. Berührungsgesteuerte Anzeigevorrichtung nach einem der vorangehenden Ansprüche, wobei:
die Infrarotstrahlquelle (200) auf der organischen lichtemittierenden Diodenanzeige angeordnet ist, die berührungsgesteuerte Anzeigevorrichtung weiterhin eine Totalreflexionsplatte (500) umfasst, die der Infrarotstrahlquelle (200) benachbart auf der organischen lichtemittierenden Diodenanzeige positioniert ist und dazu ausgestaltet ist, den von der Infrarotstrahlquelle darin ausgestrahlten ersten Infrarotstrahl vollständig zu reflektieren, und
die Berührung auf die Totalreflexionsplatte (500) erfolgt.

15. Berührungsgesteuerte Anzeigevorrichtung nach Anspruch 13 oder 14, weiterhin umfassend:
eine Erfassungsplatte (600), die unter der Anzeigetafel angeordnet ist, wobei der Infrarotstrahlsensor (300) auf der Erfassungsplatte angebracht ist.

## Revendications

1. Dispositif (1005) d'écran tactile, comprenant :
un écran (101) à diodes électroluminescentes organiques ;
une source (200) de rayonnement infrarouge constituée pour projeter un premier rayonnement infrarouge sur la surface de l'écran à diodes électroluminescentes organiques ; et
un capteur (300) de rayonnement infrarouge placé sous l'écran à diodes électroluminescentes organiques et constitué pour capter un second rayonnement infrarouge qui est dirigé, par un toucher, en direction de l'écran à diodes électroluminescentes organiques à partir du premier rayonnement infrarouge et transmis à travers une zone de transmission de l'écran à diodes électroluminescentes organiques,
**caractérisé en ce que** l'écran (101) à diodes électroluminescentes organiques comprend :
une zone d'affichage comprenant une couche électroluminescente organique (720) émettant de la lumière, et une première électrode (710) et une seconde électrode (730) se faisant face l'une à l'autre, la couche électroluminescente organique étant interposée entre les première et seconde électrodes ; et
**en ce que** la zone de transmission est adjacente à la zone d'affichage et comprend une partie (731) de la seconde électrode (730) qui est espacée du reste de la seconde électrode par une zone d'espacement et une partie en saillie (165) sur laquelle s'appuie la partie de la seconde électrode,
dans lequel l'écran est constitué pour transmettre de la lumière projetée depuis l'extérieur à travers la zone d'espacement.

2. Dispositif d'écran tactile selon la revendication 1, dans lequel l'écran (101) à diodes électroluminescentes organiques comprend en outre : un transistor à couches minces (20) comprenant une électrode de source (176) et une électrode de drain (174) constituée pour transmettre un signal d'attaque à la première électrode (710).

3. Dispositif d'écran tactile selon la revendication 1 ou 2, dans lequel l'écran à diodes électroluminescentes organiques comprend en outre une couche définie de pixels (162) définissant la zone d'affichage par exposition de la première électrode (710), dans lequel la partie en saillie (165) fait saillie depuis la couche définie de pixels.

4. Dispositif d'écran tactile selon l'une quelconque des revendications précédentes, dans lequel un côté de la partie en saillie (165) est en cône inversé.

5. Dispositif d'écran tactile selon l'une quelconque des revendications précédentes, dans lequel la partie en saillie (165) a une configuration en îlot.

6. Dispositif d'écran tactile selon l'une quelconque des revendications précédentes, dans lequel la partie en saillie (165) s'étend dans une direction.

7. Dispositif d'écran tactile selon l'une quelconque des revendications précédentes, dans lequel la zone de transmission comprend une pluralité de parties en saillie (165).

8. Dispositif d'écran tactile selon la revendication 7, dans lequel les parties en saillie (165) sont agencées en un motif en matrice.

9. Dispositif d'écran tactile selon la revendication 7, dans lequel les parties en saillie (165) sont agencées en un motif en bandes.

10. Dispositif d'écran tactile selon l'une quelconque des revendications précédentes, dans lequel la première électrode (710) transmet la lumière, et la seconde électrode (730) réfléchit la lumière.

11. Dispositif d'écran tactile selon l'une quelconque des revendications précédentes comprenant en outre : une couche (400) de transmission du rayonnement infrarouge, constituée pour transmettre le second rayonnement infrarouge, placée entre l'écran (101) à diodes électroluminescentes organiques et le capteur (300) de rayonnement infrarouge.

12. Dispositif d'écran tactile selon la revendication 11, dans lequel la couche (400) de transmission du rayonnement infrarouge arrête la longueur d'onde d'une région de lumière visible.

13. Dispositif d'écran tactile selon l'une quelconque des revendications précédentes,
dans lequel la source (200) de rayonnement infrarouge est placée sous l'écran (101) à diodes électroluminescentes organiques, constituée pour projeter le premier rayonnement infrarouge sur la surface de l'écran à diodes électroluminescentes organiques à travers la zone de transmission de l'écran à diodes électroluminescentes organiques, et
dans lequel le toucher se fait sur l'écran à diodes électroluminescentes organiques.

14. Dispositif d'écran tactile selon l'une quelconque des revendications précédentes,
dans lequel la source (200) de rayonnement infrarouge est placée sur l'écran à diodes électroluminescentes organiques, le dispositif d'écran tactile comprend en outre une plaque (500) à réflexion totale placée sur l'écran à diodes électroluminescentes organiques, adjacente à la source (200) de rayonnement infrarouge et constituée pour réfléchir totalement le premier rayonnement infrarouge projeté sur celle-ci par la source de rayonnement infrarouge, et
dans lequel le toucher se fait sur la plaque (500) à réflexion totale.

15. Dispositif d'écran tactile selon la revendication 13 ou 14, comprenant en outre : une plaque (600) placée sous le panneau d'affichage, dans lequel le capteur (300) de rayonnement infrarouge est monté sur la plaque de détection.
